# EUROPEAN PATENT APPLICATION

(11) **EP 3 696 853 A1**
(43) Date of publication of application: **19.08.2020**
(21) Application number: 19877541.3
(22) Date of filing: 07.01.2019
(51) Int. Cl.: H01L 25/065

(54) **POWER SEMICONDUCTOR CHIP PACKAGE STRUCTURE**

(30) Priority: 12.12.2018 CN 201811520417
(71) Applicant: SHENZHEN FANGJING TECHNOLOGY CO., LTD., 1202 Guangdong 518000 (CN)
(72) Inventor: ZHAN, Chuangfa, Yichang, Hubei 443600 (CN)
(74) Representative: Zaboliene, Reda
(86) International application number: PCT/CN2019/070599
(87) International publication number: WO 2020/118818

(57) **Abstract**

Claimed is a Surface Mount Technology (SMT) structure of power semiconductor, which includes a substrate (100) and a conductive metal layer (200) covered on the substrate (100). A number of conductive poles (201) are integrally formed on the conductive metal layer (200). The SMT structure of power semiconductor also includes a number of semiconductor chips (400) which are fixed on the conductive metal layer (200) through a conductive connection layer (300) and the height of which after being fixed is the same as that of the conductive poles, and an insulating layer (500) which packages the conductive poles (201) and the semiconductor chips (400) on the same side of the substrate (100). There are bonding pads (600) penetrating through the insulating layer (500) provided on the tops of the conductive poles (201) and the semiconductor chips (400) respectively. According to the SMT structure of the power semiconductor, the conductive pole (201) is used to import current flowing through one or more electrodes under the semiconductor chip (400) to the upper side, so that all conductive electrode bonding pads (600) are on the same side after the semiconductor chip (400) is packaged. The structure has simple process, fewer process steps, reasonable structure design, small volume, and wide application scope; moreover, the structure has low package material consumption and low product manufacture cost, so it can meet the needs of the market.

## Description

### Technical Field

The disclosure relates to the field of semiconductor packaging technology, in particular to a Surface Mount Technology (SMT) structure of power semiconductor.

### Background

The SMT is an emerging industrial technology in the electronic industry, its rise and rapid development is a revolution in the electronic assembly industry, and it enables electronic assembly to become faster and easier, followed by a higher and higher updating speed of a variety of electronic products, a higher and higher integration level, and a cheaper and cheaper price. With the rise of wearable electronic devices, a requirement for a reduced size of surface mounting package is higher and higher. The existing power semiconductor devices are mainly divided into a Vertical Double-Diffused Metal Oxide Semiconductor (VDMOS), a Bipolar Junction Transistor (BJT), and a diode, which are vertical power semiconductor devices. The power semiconductor SMT is packaging, on a fixed frame, a power semiconductor chip in a specific SMT form through five main processes, namely die bonding, wire bonding, plastic package, electroplating and molding. However, the shape size of the existing SMT structure is large, so it is not suitable for wearable electrical devices and mobile electronic devices requiring small space, it is difficult to completely meet the requirements of the market, and its size limits the scope of its application; besides, the size is large, the material consumption is high, and the cost of packaging a single chip is high, so it is not conductive to marketing.

Therefore, how to solve the above technical problems is a technical problem to be solved urgently in the industry.

### Summary

The main purpose of the disclosure is to provide an SMT structure of power semiconductor, aiming at realizing an SMT structure of power semiconductor with simple process, reasonable structure design, small size, low material consumption and low cost.

The disclosure presents an SMT structure of power semiconductor, which includes a substrate and a conductive metal layer covered on the substrate. A number of conductive poles are integrally formed on the conductive metal layer. The SMT structure of power semiconductor also includes a number of semiconductor chips which are fixed on the conductive metal layer through a conductive connection layer and the height of which after being fixed is the same as that of the conductive poles, and an insulating layer which packages the conductive poles and the semiconductor chips on the same side of the substrate. There are bonding pads penetrating through the insulating layer provided on the tops of the conductive poles and the semiconductor chips respectively.

Preferably, the thickness of the bonding pad is set as 1um to 200um.

Preferably, the substrate is made of a material selected from metal, silicon, ceramics, sapphire or glass.

Preferably, the insulating layer is made of a material selected from epoxy resin, silica gel, ceramics, photoresist or polyimide.

According to the SMT structure of power semiconductor, the conductive metal layer is covered on the substrate, a number of raised conductive poles are formed in the process of forming the conductive metal layer, at the same time, the semiconductor chips are fixed on the conductive metal layer through the conductive connection layer, and the height of the semiconductor chips is the same as that of the conductive poles; there are the bonding pads provided on the tops of the conductive poles and the semiconductor chips respectively, and the bonding pad is set as a conductive electrode; at last, the semiconductor chips and the conductive poles are packaged through the insulating layer, and the bonding pad penetrates through the insulating layer. In the disclosure, the semiconductor chips and the conductive poles are provided on the same side of the substrate, and the height of the semiconductor chips is the same as that of the conductive poles; the conductive pole imports the current flowing through one or more electrodes under the semiconductor chip to the upper side, so that all the bonding pads of the conductive electrodes are on the same side after the semiconductor chips are packaged; in this way, a manner of separately arranging the electrodes of a vertical power semiconductor on both sides is converted into a manner of arranging the electrodes and the bonding pads on the same side. By using the conductive pole to conduct the current, compared with the traditional wire bonding process, the disclosure has higher current density, simple process of package and bonding pad, fewer process steps, and reasonable structure design, and greatly reduces the size of package on the basis of realizing the vertical current conduction of the semiconductor chip. A package dimension of the SMT structure of power semiconductor is only slightly larger than that of the semiconductor chip, and achieves the chip-level package size. Because of the small size and low package material consumption, the cost of raw materials is greatly reduced, and then the product manufacture cost is reduced, which improves the market competitiveness of products.

### Brief Description of the Drawings

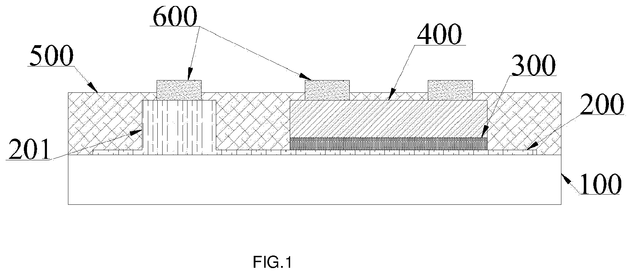

Fig. 1 is a section structure diagram of an embodiment of an SMT structure of power semiconductor according to the disclosure.

The realization of the purpose, functional features and advantages of the disclosure will be further illustrated in combination with the embodiments and with reference to the drawings.

### Detailed Description of the Embodiments

It is to be understood that the specific embodiments described here are only used for explaining the disclosure, but not for limiting the disclosure.

With reference to Fig. 1, an embodiment of an SMT structure of power semiconductor of the disclosure is presented, which includes: a substrate 100 and a conductive metal layer 200 covered on the substrate 100. The substrate 100 may be made of metal. In the present embodiment, the substrate 100 may be made of a material selected from silicon, ceramics, sapphire or glass according to specific needs. The conductive metal layer 200 is covered on the substrate 100 in an abnormal shape. The conductive metal layer 200 in the present embodiment may be covered on the substrate 100 by means of evaporation. The conductive metal layer 200 functions in conductivity. A number of raised conductive poles 201 are integrally formed in the process of forming the conductive metal layer 200. The conductive pole 201 and the conductive metal layer 200 are integrally formed on the substrate 100 to function in conductivity. The conductive pole 201 has higher current density than the wire bonding process in the traditional package structure. The conductive metal layer 200 in the present embodiment may also be covered on the substrate 100 by means of one of electroplating, chemical plating or hot pressing.

The SMT structure of power semiconductor further includes a semiconductor chip 400 fixed on the conductive metal layer 200 through a conductive connection layer 300. After the semiconductor chip 400 is fixed on the conductive metal layer 200, its height is the same as that of the conductive pole 201. There are bonding pads 600 respectively provided on the tops of the conductive pole 201 and the semiconductor chip 400. The bonding pads 600 are formed on the conductive pole 201 and the semiconductor chip 400 by means of tin welding and used as electrodes. The thickness of the bonding pad 600 is set as 1um to 200um, so the bonding pad has small thickness, small size, and occupies little space. Thus, the conductive pole 201 and the semiconductor chip 400 are provided on the same side of the substrate 100, and the bonding pads provided on the conductive pole 201 and the semiconductor chip 400 are also provided on the same side, which perfectly completes the conversion from a manner of separately arranging the bonding pads 600 of a vertical power semiconductor on both sides to a manner of arranging the bonding pads 600 on the same side. The structure can greatly reduce the package size, and control the package size to less than 3 times the size of the semiconductor chip 400, and even less than 1.5 times. By using the structure which has small size and low package material consumption, the cost of raw materials is greatly reduced, and then the product manufacture cost is indirectly reduced, and the market competitiveness of products is improved while the process is simplified. At last, the semiconductor chips 400 and the conductive poles 201 are packaged on the substrate 100 through the insulating layer 500, and the bonding pad 600 penetrates through the insulating layer 500. The insulating layer 500 protects the sides of the conductive pole 201 and the semiconductor chip 400 to function in insulation protection. The insulating layer 500 is made of epoxy resin, so its insulation performance is good, and its structure is stable and reliable. The insulating layer may also be made of a material selected from silica gel, ceramics, photoresist or polyimide.

With the rise of wearable electronic devices, a requirement for a reduced size of SMT is higher and higher. The existing power semiconductor devices are mainly divided into a VDMOS, a BJT, and a diode, which are vertical power semiconductor devices. The power semiconductor SMT is encapsulating, on a fixed frame, the power semiconductor chip 400 in a specific SMT form through five main processes, namely die bonding, wire bonding, plastic package, electroplating and molding. However, the shape size of the existing SMT structure is large, so it is not suitable for wearable electrical devices and mobile electronic devices requiring small space, it is difficult to completely meet the requirements of the market, and its size limits the scope of its application; besides, the size is large, the material consumption is high, and the cost of packaging a single chip is high, so it is not conductive to marketing.

In order to solve the existing technical problems, the SMT structure of power semiconductor of the disclosure is presented, which includes: the substrate 100, the conductive metal layer 200 provided in an abnormal shape, the semiconductor chip 400, the bonding pad 600, and the insulating layer 500. The conductive metal layer 200 has a function of conductivity, and a number of conductive poles 201 are integrally formed in its forming process. The bonding pad 600 is formed on the conductive pole 201 by means of tin welding. The conductive pole 201 imports the current flowing through one or more electrodes under the semiconductor chip 400 to the upper side. In this way, the structure realizes the vertical current conduction, and has higher current density than that of the traditional wire bonding process. The semiconductor chip 400 is fixed on the conductive metal layer 200 through the conductive connection layer 300, and the height of the fixed semiconductor chip 400 is the same as that of the conductive pole 201; there is the bonding pad 600 formed on the semiconductor chip 400 respectively by means of tin welding, the conductive pole 201 and the semiconductor chip 400 are provided on the same side of the substrate 100, and the bonding pad 600 provided on the conductive pole 201 and the bonding pad 600 provided on the semiconductor chip 400 are on the same side; the conductive pole 201 imports the current flowing through one or more electrodes under the semiconductor chip 400 to the upper side, so that all the conductive electrodes are on the same side by means of tin welding after the semiconductor chips are packaged. In this way, a manner of separately arranging the electrodes of the power semiconductor on the upper side and the lower side during vertical current conduction is converted into a manner of welding the electrodes of the power semiconductor on the same side by means of tin welding, and the size after package is reduced on the basis of realizing the vertical current conduction of the semiconductor chip. The disclosure uses the insulating layer 500 to protect the sides of the conductive pole 201 and the semiconductor chip 400, which greatly reduces the size after package. A package dimension of the SMT structure of power semiconductor is only slightly larger than that of the semiconductor chip 400, and achieves the chip-level package size; besides, the structure has a small size, so it is suitable for wearable electrical devices and mobile electronic devices requiring small space, may completely meet the requirements of the market, and has a wide scope of application. Because of the low package material consumption, the cost of raw materials is greatly reduced, and then the product manufacture cost is reduced, which improves the market competitiveness of products. Moreover, by using the conductive pole 201 to conduct the current, compared with the traditional wire bonding process, the disclosure has higher current density, simple process of package and bonding pad 600, fewer process steps, and reasonable and practical structure design.

Therefore, the disclosure realizes an SMT structure of power semiconductor with simple process, reasonable structure design, small size, low material consumption and low cost.

The above is only the preferred embodiments of the disclosure, not limiting the scope of patent protection of the disclosure; all equivalent structure transformations made through the contents of the specification and accompanying drawings of the disclosure or directly or indirectly applied to other related technical field are similarly included in the scope of patent protection of the disclosure.

## Claims

1. A Surface Mount Technology (SMT) structure of power semiconductor, comprising: a substrate and a conductive metal layer covered on the substrate, wherein a number of conductive poles are integrally formed on the conductive metal layer; the SMT structure of power semiconductor further comprises a number of semiconductor chips which are fixed on the conductive metal layer through a conductive connection layer and the height of which after being fixed is the same as that of the conductive poles, and an insulating layer which packages the conductive poles and the semiconductor chips on the same side of the substrate;
there are bonding pads penetrating through the insulating layer provided on the tops of the conductive poles and the semiconductor chips respectively.

2. The SMT structure of power semiconductor as claimed in claim 1, wherein the thickness of the bonding pad is set as 1um to 200um.

3. The SMT structure of power semiconductor as claimed in claim 1 or 2, wherein the substrate is made of a material selected from metal, silicon, ceramics, sapphire or glass.

4. The SMT structure of power semiconductor as claimed in claim 3 wherein the insulating layer is made of a material selected from epoxy resin, silica gel, ceramics, photoresist or polyimide.
